Europäisches Patentamt

**European Patent Office**

Office européen des brevets

(11) Publication number: **0 157 008 B1**

## EUROPEAN PATENT SPECIFICATION

(45) Date of publication of patent specification: **19.06.91**

(51) Int. Cl.⁵: **H01L 23/31**, H01L 23/00, H01L 23/58

(21) Application number: **84116284.5**

(22) Date of filing: **24.12.84**

(54) **Electronic device having a package.**

(30) Priority: **06.04.84 JP 67713/84**

(43) Date of publication of application:
**09.10.85 Bulletin 85/41**

(45) Publication of the grant of the patent:
**19.06.91 Bulletin 91/25**

(84) Designated Contracting States:
**DE FR GB IT**

(56) References cited:
**EP-A- 0 090 439**
**DE-A- 2 925 509**
**FR-A- 2 075 958**
**US-A- 4 258 652**

**PATENTS ABSTRACTS OF JAPAN, vol. 8, no.
115 (E-247)[1552], 29th May 1984 & JP - A - 59
28 361**

(73) Proprietor: **HITACHI, LTD.
6, Kanda Surugadai 4-chome
Chiyoda-ku, Tokyo 100(JP)**

(72) Inventor: **Oka, Noriaki
391-8, Nishiyokote-machi
Takasaki-shi Gunma(JP)**

(74) Representative: **Strehl, Schübel-Hopf, Groen-
ing
Maximilianstrasse 54 Postfach 22 14 55
W-8000 München 22(DE)**

EP 0 157 008 B1

## Description

This invention relates to an electronic device. In recent years, in a semiconductor integrated circuit, the size of an element has become still finer with enhancement in the density of integration. The finer the element becomes in this manner, the more the electrostatic breakdown strength lowers.

According to the inventor's study, it has been revealed that the frequency of the electrostatic breakdown of semiconductor devices has conspicuously increased recently.

The inventor made researches on means for preventing the electrostatic breakdown of a semiconductor device. In the course, he has found out a new mechanism for the occurrence of electrostatic breakdown differing from the cause of electrostatic breakdown, having hitherto been considered, which is the contact of a part of the human body with the semiconductor device.

In view of the new mechanism for the occurrence of electrostatic breakdown to be described later, the inventor further thought out a countermeasure. With the countermeasure, however, it has been revealed that clear and durable marking which employs a laser beam cannot be applied to the semiconductor device.

JP-A-59-28361 discloses an electronic device of the type set forth in the first part of claim 1. The resin package of that device has all smooth surfaces with a marking formed by raised charcters provided on one surface. A clear marking can thereby be achieved, and electrostatic breakdown as had been observed a a result of conventional imprinting technique can be avoided.

## SUMMARY OF THE INVENTION

It is an object of the invention to provide an electronic device which exhibits an increased resistance to electrostatic breakdown and which can be more readily provided with a clear marking.

The electronic device defined in claim 1 meets this object.

In the device according to the present invention, the roughened surface that may come into contact with a metallic handling appliance, decreases the area of contact between the package and the appliance, thereby reducing any frictional electricity that may be produced thereby, so that the electronic element within the package is prevented from becoming defective on account of electrostatic breakdown attributed to the handling by such metallic appliances. On the other hand, since the marking surface portion is smooth, preferably mirror-finished, it is easily marked by means of a laser beam.

## Brief Description of the Drawings

Figs. 1(a) - 1(c) are model diagrams for explaining the technical background of this invention;

Fig. 2 is a diagram showing an example in the case where a semiconductor integrated circuit device formed with an LS-TTL (Low Power Schottky-TTL) is broken down;

Fig. 3 is a front sectional view showing am embodiment of a semiconductor integrated circuit device according to this invention;

Fig. 4 is a side view of the semiconductor integrated circuit device shown in Fig. 3;

Fig. 5 is a bottom view of the semiconductor integrated circuit device shown in Fig. 3;

Fig. 6 is a top view of the semiconductor integrated circuit device shown in Fig. 3;

Figs. 7(a) and 7(b) are graphs showing the results of electrification tests which were performed as to a semiconductor integrated circuit device according to this invention and a semiconductor integrated circuit device not falling within this invention, respectively;

Fig. 8 shows another embodiment of this invention, and is a perspective view of that package of the semiconductor integrated circuit device in which only the marking parts of the upper surface thereof are formed into mirror finished surfaces;

Fig. 9 is a view showing an example of the transport aspect of the semiconductor integrated circuit device shown in Fig. 8;

Fig. 10 shows a modification of the semiconductor integrated circuit device shown in Fig. 8, and is a perspective view of the IC whose upper surface has both its end parts, corresponding to the longitudinal direction thereof, roughened;

Fig. 11 shows another modification of the semiconductor integrated circuit device shown in Fig. 8, and is a perspective view of the IC whose upper surface has a roughened part surrounding a mirror finished surface part;

Fig. 12 shows still another embodiment of this invention, and is a side view of the semiconductor integrated circuit device which has a plurality of protrusions at its rear surface;

Fig. 13 shows the state of the protrusions in Fig. 12, and is a rear view of the IC which is formed with two ridges in the longitudinal direction thereof; and

Fig. 14 shows the state of the protrusions in Fig. 12, and is a rear view of the IC which is formed with a plurality of semispherical bumps at its rear surface.

Description of Preferred Embodiments

First of all, there will be explained the new mechanism for the occurrence of electrostatic breakdown in a semiconductor device, which has been found out by the inventor.

Unlike the electrostatic breakdown ascribable to human static electricity having hitherto been considered, the new electrostatic breakdown is caused by static electricity arising due to the friction between the semiconductor device and a handling appliance which is used for moving the semiconductor device.

More specifically, a semiconductor integrated circuit device is manipulated with a handling appliance which is formed in the shape of a rail. The handling appliance is constructed as, for example, a chute which slides and conveys the semiconductor integrated circuit device or a magazine which stores the semiconductor integrated circuit device. This handling appliance is often made of a metal, e. g., aluminum for such reasons as protecting a semiconductor integrated circuit device from electrostatic breakdown and ensuring a mechanical strength for the handling appliance.

For example, the handling appliance to be used as the chute is substantially constructed of a metallic guide rail. The semiconductor integrated circuit device is slidden along the rail, thereby to perform the operations of supplying the semiconductor integrated circuit device to a test equipment for electrical characteristics and a marking equipment in succession. The tested or marked semiconductor integrated circuit device is also guided by the handling appliance until it is discharged therefrom.

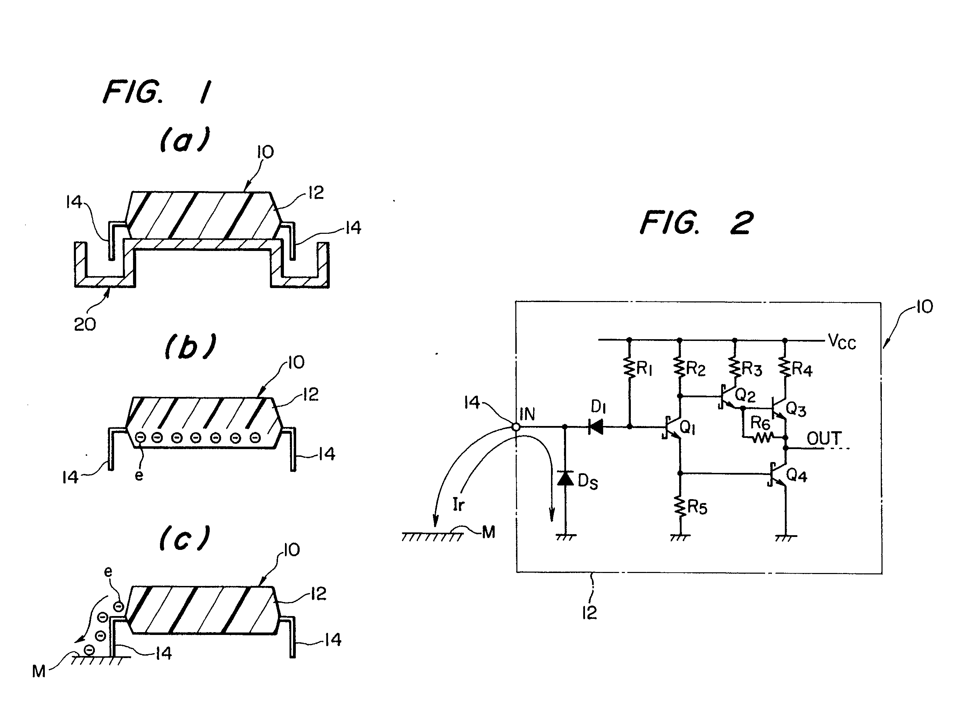

Here, the process of the occurrence of a defective unit due to the handling appliance, which the inventor has analyzed, will be explained in accordance with a model illustrated in Figs. 1(a) - 1(c).

As shown in Fig. 1(a), a dual in-line type semiconductor integrated circuit device (hereinbelow, abbreviated to "IC") 10 which is sealed with a resinous package 12 and which has pin terminals 14 arrayed on both its sides is taken as an example, and this IC 10 is transported by being slidden on a metallic guide rail 20 astride the same. On this occasion, the package 12 of the IC 10 lies in contact with the slide surface of the rail 20 under a surface contact state.

Then, as shown in Fig. 1(b), electrostatic charges e are sometimes stored on the side of the package 12 of the IC 10 due to the friction between the resin of the package 12 and the metal of the guide rail 20.

Here, as shown in Fig. 1(c), when the pin terminal 14 of the IC 10 touches a metal M being an electric conductor, the charges e having been stored during the sliding transport of the IC on the guide rail 20 are instantly discharged from the terminal 14 to the metal M as indicated by an arrow. A discharge shock at this time breaks down the internal circuit of the IC 10.

In this case, the metallic guide rail itself is considered as the metal M to which the stored charges e are discharged. More specifically, when the pin terminal 14 touches the metallic guide rail 20 with the package 12 bearing a large quantity of charges, a discharge current instantly flows between the terminal 14 and the rail 20 accordingly, and a transient shock at this time leads the internal circuit to breakdown. However, such breakdown does not always occur, but it occurs only when a large quantity of electrostatic charges are stored in the package 12 and they are discharged at a stroke. That is, the occurrence of the breakdown involves many indefinite factors, and this has made it very difficult to clear up the cause.

Further, it has been revealed by the inventor that the breakdown phenomenon as stated above arises, not only in a MOS IC, but also in a bipolar IC, especially an IC formed with a low power Schottky-TTL (LS-TTL) as its internal circuit.

Fig. 2 shows an example of the breakdown state of an IC 10 formed with an LS-TTL as its internal circuit. A terminal 14 touches an external metal M when a resinous package 12 has stored a large quantity of electrostatic charges. Then, the stored electrostatic charges are instantly discharged to the metal M via a clamp diode for input protection $D_s$ and the terminal 14. Thus, a surge current $I_r$ flows in the reverse direction of the clamp diode $D_s$ to break down this diode $D_s$.

Symbol $V_{cc}$ in Fig. 2 denotes the operating supply voltage of the LS-TTL.

This invention has been made with note taken of the problem as thus far described.

Now, typical embodiments of this invention will be described with reference to the drawings.

In the drawings, identical or corresponding portions are indicated by the same symbols.

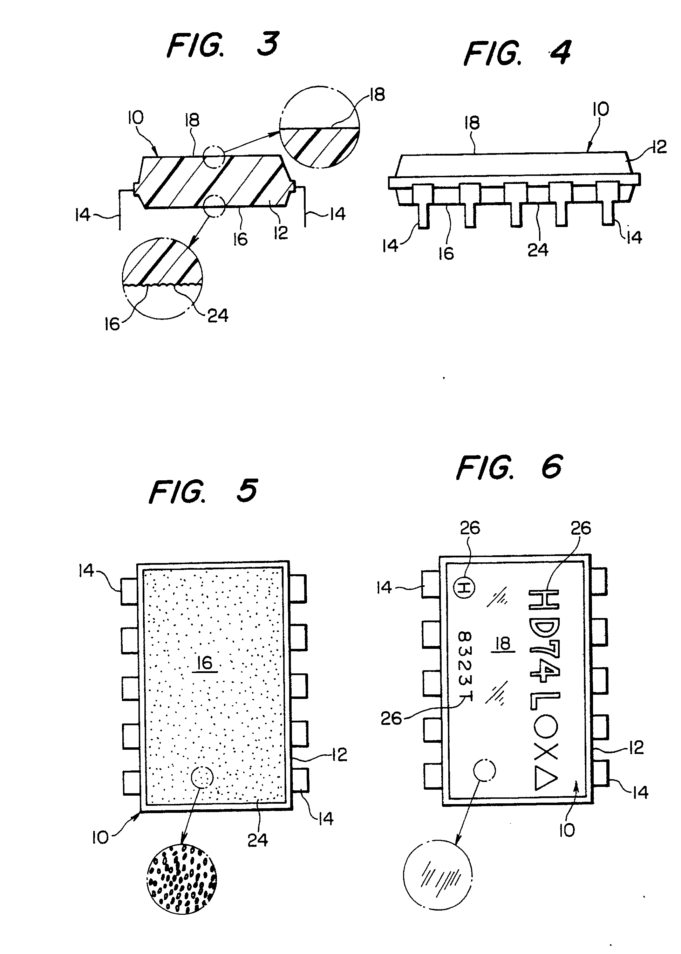

Figs. 3 to 6 show one embodiment of an IC according to this invention.

The IC 10 shown in Figs. 3 - 6 is such that an IC chip formed with, e. g., an LS-TTL is sealed with a resinous package 12 . Pin terminals 14 are arrayed on both the sides of the package 12, into a packaging form of the so-called dual in-line type.

3

The package 12 is formed in the shape of a flat box, and the pin terminals 14 are respectively arrayed at both the side parts thereof. The upper surface 18 of the package 12 is formed into a mirror finished surface. Further, the upper surface 18 is formed with marking 26 indicative of a model number etc. by directly printing it with a laser beam by way of example. On the other hand, the lower surface 16 of the package 12 is formed with an aventurine roughened surface 24. This roughened surface 24 can be formed by the very simple expedient of partly omitting the lapping of the molding surface of a metal mold for molding the package 12. When the package 12 is set on a handling appliance such as chute or magazine, numerous minute protrusions forming the aventurine roughened surface 24 intervene between the package 12 and the handling appliance and function to decrease the contact area between them.

According to the IC 10 formed with the roughened surface 24 which lies between the package 12 and the handling appliance and functions to reduce the contact area between them as described above, the state of contact between the package 12 and the handling appliance does not become a surface contact state but becomes a point contact or partial contact state. That is, the effective contact area lessens sharply. It has been verified that, in consequence, the occurrence of static electricity acribable to the friction between the resin of the package 12 and the metal of the handling appliance diminishes sharply and reliably. This fact has brought forth the effect that, even when the pin terminal 14 of the IC 10 touches the metal part of the handling appliance by way of example, a discharge shock to arise between the side of the IC 10 and the metal side on the occasion is suppressible to be sufficiently lower than the breakdown level of the IC.

Meanwhile, the upper surface 18 of the package 12 is formed into the mirror finished surface. Therefore, when it is formed with the marking 26 with, e. g., a laser beam by direct printing, the contrast between the printed parts and the background part appears clearly, whereby the marking 26 which is very legible and which is not readily erased can be obtained.

If the marking surface of the IC package is also an aventurine surface of numerous minute rugged parts, marking formed by laser irradiation will become unclear.

The reason is as follows. Laser marking is such that a part of the marking surface is irradiated by a laser so as to have its composition changed, whereby only the part is enabled to reflect light irregularly. When the whole marking surface is originally the surface of the minute ruggedness adapted to irregularly reflect light, the part on which a laser bean impinges and the part on which it does not impinge do not come to have a clear contrast.

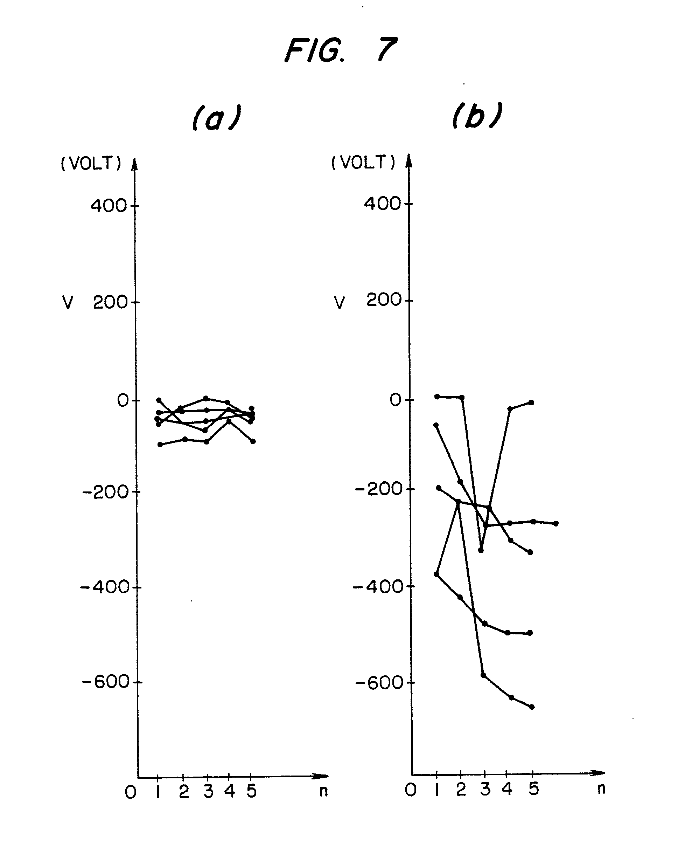

Here, Figs. 7(a) and 7(b) show results obtained when the states of electrification of IC's 10 were actually tested and compared as to the case of providing the lower surface 16 of the package 12 with the roughened surface 24 (Fig. 7(a)) and the case of smoothing the lower surface (Fig. 7(b)) respectively. In either figure, the axis of ordinates represents the charged voltage V (volts), and the axis of abscissas the number of times of measurements n (times). Test conditions were the same in both the cases, in each of which the operation of sliding the dual in-line type IC sealed with an epoxy resin on a handling appliance of metal (aluminum) in the shape of a rail 1 m long and inclined at 45 degrees was conducted 5 times, the charged voltage of the IC being measured each time. Further, the same operations were repeated five times. The IC was a logic IC which was formed with an LS-TTL by micro-processing. The measurement of the charged voltage was performed with a Faraday gauge.

As apparent from the test results in Figs. 7(a) and 7(b), according to the device of the present invention formed with the roughened surface 24, the quantities of electrification could be reduced and their dispersion width could be narrowed as illustrated in Fig. 7(a). In contrast, with the device in which the lower surface of the package was smooth, the quantities of electrification were large as a whole and their dispersion width was great, the charged voltage exceeding -600 V in some cases, as illustrated in Fig. 7(b).

The numbers of occurrence of defects relative to the numbers of the samples of the IC's used for the test (the numbers of occurrence of defects/the numbers of test samples) were as in the following table 1:

## Table 1

| Numbers of Times of Tests | 1st test | 2nd test | 3rd test | 4th test |
|---|---|---|---|---|
| (a) | 0/100 | 0/100 | 0/100 | 0/100 |
| (b) | 3/100 | 0/100 | 1/97 | 0/96 |

(a): IC according to the present invention, (b): IC not falling within the present invention.

As stated above, there is attained the effect that, with the very simple construction, the occurrence of defects of an IC formed with an LS-TTL etc. by microprocessing can be reliably prevented without spoiling the clearness of marking. Furthermore, there is simultaneously attained the effect that, since the roughened surface 24 can also be formed by partially omitting the lapping of the molding surface of a metal mold for molding a package by way of example, the lapping cost of the metal mold can be curtailed.

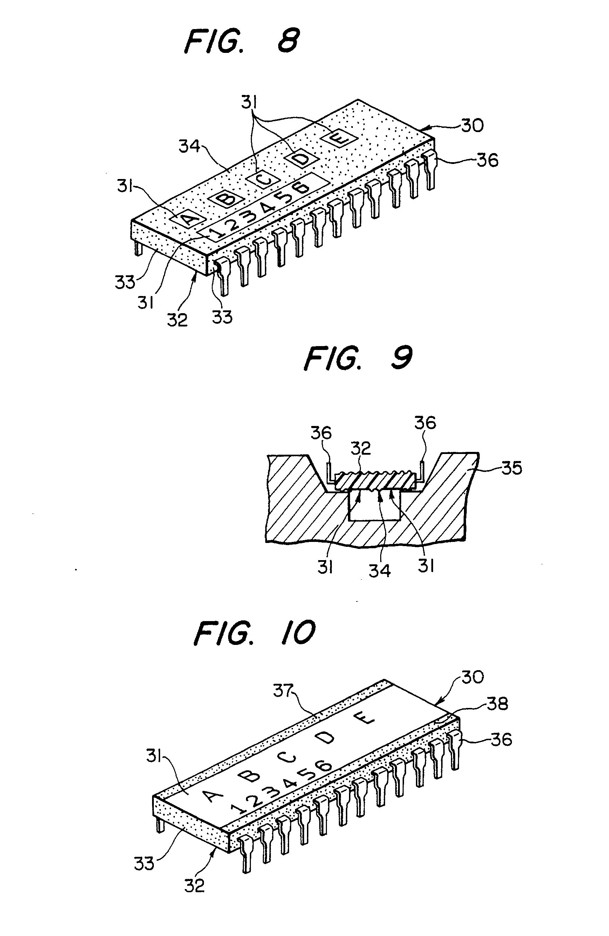

Fig. 8 is a perspective view showing the aspect of an IC package in another embodiment of the present invention.

An illustrated IC 30 differs from the IC 10 shown in Fig. 3, in the following construction.

The feature of the IC 30 shown in Fig. 8 is that only parts 31 to be marked with a laser are formed into mirror finished surfaces, whereas the other places, e. g., a rear surface 32, side surfaces 33 and the part 34 of a marking surface not to be marked are formed into roughened surfaces.

Also with the above construction, the object of the present invention can be satisfactorily achieved. Besides, effects similar to those of the preceding embodiment are attained.

Further, the present construction prevents the IC from becoming defective even when a transport aspect as illustrated in Fig. 9 is employed. More specifically, even when parts of the marking surface of the IC lie in contact with a chute 35 or the like as shown in Fig. 9, the area of the contact is small because the contact parts are roughened, so that the occurrence of electrostatic charges can be sufficiently reduced.

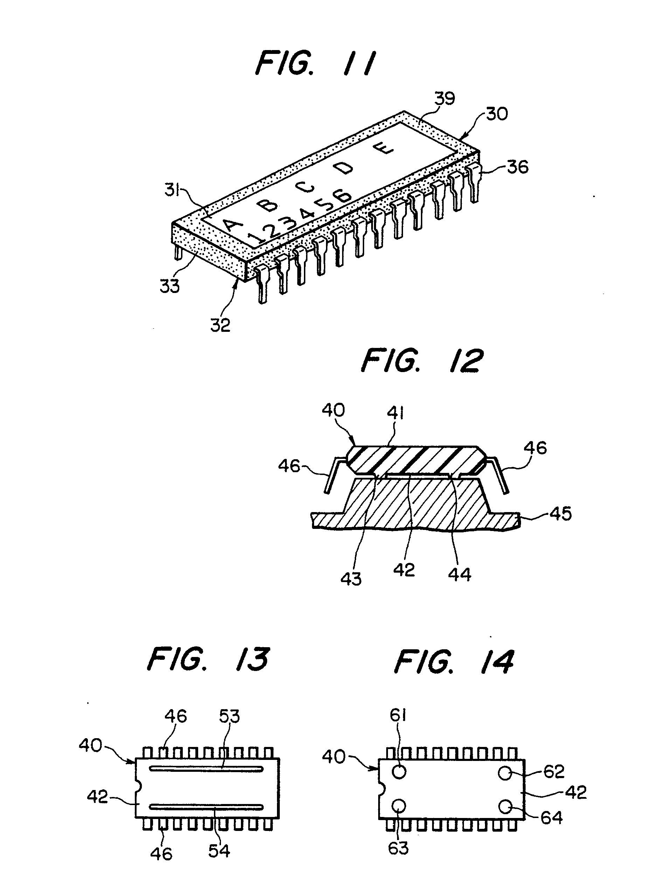

Figs. 10 and 11 show modifications of the embodiment in Fig. 8.

In the case where the front surface 31 of the IC 30 is brought into contact with the chute 35 or the like as depicted in Fig. 9, at least both the end parts of the IC extending in the longitudinal direction thereof may be roughened. In the modification of Fig. 10, therefore, both the end parts 37 and 38 of the IC 30 extending in the longitudinal direction thereof are formed into roughened surfaces. The modification of Fig. 11 is provided with a roughened surface portion 39 which surrounds the part 31 of the IC 30 to be marked.

Fig. 12 shows still another embodiment of the present invention. In each of the foregoing two embodiments, the rear surface 16 or 32 of the IC 10 or 30 has been roughened thereby to diminish the contact area thereof with, for example, the handling appliance. In contrast, according to the present embodiment, the expedient of roughening the rear surface of an IC is not adopted, but the rear surface is provided with a plurality of protrusions thereby to diminish the area of its contact with the metal surface of the handling appliance.

The embodiment will now be described with reference to the drawing. An IC 40 shown in Fig. 12 has its front surface 41 formed into a mirror finished surface. For this reason, clear marking is possible even with a laser. In addition, the rear surface 42 of the IC 40 is formed with a plurality of protrusions 43 and 44. These protrusions 43 and 44 reduce the area of the contact of the rear surface with the metal part 45 of a handling appliance or the like. Thus, effects similar to those of the foregoing two embodiments are attained. Numerals 46 indicate lead frames (pins).

The practicable constructions of the protrusions 43 and 44 are shown in Figs. 13 and 14. In the construction of Fig. 13, the rear surface 42 is provided with two ridges 53 and 54 in the longitudinal direction of the IC 40 as corresponding to the protrusions 43 and 44. The ridges 53 and 54 can be readily formed merely by providing recesses (shallow slots) in the corresponding parts of a metal mold. In the illustration, the number of the ridges is set at two so as to ensure the minimum contact area and the stability of the IC on the handling appliance. However, it is not restrictive, but ridges in a larger number such as three or four may well be provided though not shown. On the other hand, Fig. 14 shows an example in which semispherical bumps 61, 62, 63 and 64 are provided near the four corners of the IC 40. This construction can also be realized by forming semispherical indents in the corresponding parts of a metal mold. The protrusions shown in Fig. 13 or Fig. 14 can be formed merely by scratching or cutting the metal mold presently in use with a hard metal such as steel, and this is advantageous in point of cost. The marking surface of the IC shown in Fig. 13 or Fig. 14 is formed as illustrated in Fig. 3 or Fig. 8. The rear surface 42 of the IC, however, may be either a mirror finished surface or a roughened surface because the contact area of the rear surface with the metal of the handling appliance or the like is small owing to the protrusions. The roughened surface will be preferable for preventing the electrostatic breakdown more reliably.

According to the embodiments of the present invention described above, the following effects are attained:

(1) Since the lower surface of a package is formed into a roughened surface, the area of its contact with a handling appliance or the like can be decreased. Thus, static electricity to arise due to the friction between the handling appliance and the package can be reduced to prevent the electrostatic breakdown of an IC and to lessen defects after a test step and at an assembly step by a user.

(2) Since the upper surface of the package is formed into a mirror finished surface, clear marking is possible even when a laser beam is employed. That is, the contrast between printed parts formed by the laser beam and the background part appears clearly, whereby the marking which is very legible and which is not readily erased can be obtained, and the misconception of marks is avoided.

(3) The effects (1) and (2) make it possible to provide an IC whose marks can be correctly recognized and whose package stores a reduced amount of electrostatic charges. That is, it is possible to obtain the package of an IC according to which no electrostatic breakdown occurs after test and marking steps (including the user's assembly step), and moreover, the marks can be readily recognized.

(4) Further, since the roughened surface can be formed by partly omitting the lapping of the molding surface of a package forming metal mold by way of example, the lapping cost of the metal mold is curtailed, and in turn, the cost of the semiconductor device can be lowered.

(5) In a case where, as shown in Fig. 8, only the marking portions of the upper surface of an IC are formed into mirror finished surfaces and the other places are formed into roughened surfaces, clear marking can be performed, and the area of contact between the upper surface of the IC and a conveyance path can be reduced even when the IC is transported while holding its upper surface in contact with the conveyance path made of metal. That is, electrostatic charges to develop due to friction can be lessened to prevent electrostatic breakdown.

## Claims

1. An electronic device comprising a package (12) sealing an electronic element (10), being made of resin and having first and second principal planar resin surfaces (16, 18), the first surface being provided with a marking (26) and having at least a portion formed as a smooth surface,
   characterized in
   that the marking (26) is formed by a laser beam on the smooth portion of the first surface (18), and
   that the second surface (16) is a roughened surface or is provided with a plurality of protrusions.

2. The device of claim 1, wherein the first surface is provided with a plurality of smooth surface portions (31) respectively surrounded by roughened surface portions (34).

3. The device of claim 1 or 2, wherein the first surface is provided with longitudinally extending roughened surface portions (37, 38) disposed on both sides of a smooth surface portion (31).

4. The device of any one of claims 1 to 3, wherein the end surfaces (33) of the package (30) extending between the first and second surfaces are roughened.

5. The device of any one of claims 1 to 4, wherein the second surface (42) includes two longitudinally extending protrusions (53, 54).

6. The device of any one of claims 1 to 4, wherein the second surface (42) includes semispherical protrusions (61...64) provided near the four corners of the package (40).

7. The device of any one of claims 1 to 6, wherein the second surface (16) comprises an aventurine roughened surface.

8. The device of any one of claims 1 to 7, wherein the smooth surface portions are mirror-finished.

9. The device of any one of claims 1 to 8, wherein the electronic element (10) is an integrated circuit having conductive leads (14) extending from the package (12) on opposite sides thereof to form a dual-in-line package semiconductor device.

**Revendications**

1. Dispositif électronique comportant un boîtier (12) renfermant de façon étanche un composant électronique (10) et réalisé en une résine possédant des première et seconde surfaces principales planes (16,18), la première surface comportant un marquage (26) et possédant au moins une partie réalisée sous la forme d'une surface lisse,
caractérisé en ce
que le marquage (26) est formé au moyen d'un faisceau laser dans la partie lisse de la première surface (18), et
que la seconde surface (16) est une surface rugueuse ou comporte une pluralité de parties saillantes.

2. Dispositif selon la revendication 1, dans lequel la première surface comporte une pluralité de parties à surface lisse (31) entourées respectivement par des parties à surface rugueuse (34).

3. Dispositif selon la revendication 1 ou 2, dans lequel la première surface comporte des parties longitudinales à surface rugueuse (37,38) disposées des deux côtés d'une partie à surface lisse (31).

4. Dispositif selon l'une quelconque des revendications 1 à 3, dans lequel les surfaces d'extrémité (33) du boîtier (30), qui s'étendent entre les première et seconde surfaces, sont rugueuses.

5. Dispositif selon l'une des revendications 1 à 4, dans lequel la seconde surface (42) comporte deux parties saillantes longitudinales (53,54).

6. Dispositif selon l'une quelconque des revendications 1 à 4, dans lequel la seconde surface (42) comprend des parties saillantes hémisphériques (61...64), prévues à proximité des quatre coins du boîtier (40).

7. Dispositif selon l'une quelconque des revendications 1 à 6, dans lequel la seconde surface (16) comporte une surface rugueuse analogue à l'aventurine.

8. Dispositif selon l'une quelconque des revendications 1 à 7, dans lequel les parties à surface lisse possède un fini spéculaire.

9. Dispositif selon l'une quelconque des revendications 1 à 8, dans lequel l'élément électronique (10) est un circuit intégré possédant des fils conducteurs (14) qui partent du boîtier (12), sur des côtés opposés de ce dernier, pour former un dispositif à semiconducteurs à boîtier à double rangée de connexions.

**Ansprüche**

1. Elektronisches Gerät mit einer ein elektronisches Bauteil (10) umschließenden Packung (12), die aus Kunstharz besteht sowie eine erste und eine zweite ebene Kunstharz-Hauptfläche (16, 18) aufweist, wobei die erste Fläche mit einer Markierung (26) versehen ist und mindestens einen als glatte Fläche ausgebildeten Teil aufweist,
dadurch gekennzeichnet,
daß die Markierung (26) mittels Laserstrahl auf dem glatten Teil der ersten Fläche (18) gebildet ist, und daß die zweite Fläche (16) eine rauhe Fläche ist oder mit einer Vielzahl von Vorsprüngen versehen ist.

2. Gerät nach Anspruch 1, wobei die erste Fläche mit einer Vielzahl von glatten Flächenabschnitten (31) versehen ist, die jeweils von gerauhten Flächenabschnitten (34) umgeben sind.

3. Gerät nach Anspruch 1 oder 2, wobei die erste Fläche mit längs verlaufenden gerauhten Flächenabschnitten (37, 38) versehen ist, die auf beiden Seiten eines glatten Flächenabschnitts (31) angeordnet sind.

4. Gerät nach einem der Ansprüche 1 bis 3, wobei die zwischen der ersten und der zweiten Fläche verlaufenden Stirnflächen (33) der Packung gerauht sind.

5. Gerät nach einem der Ansprüche 1 bis 4, wobei die zweite Fläche (42) zwei längs verlaufende Vorsprünge (53, 54) enthält.

6. Gerät nach einem der Ansprüche 1 bis 4, wobei die zweite Fläche (42) nahe den vier Ecken der Packung (40) vorgesehene halbkugelförmige Vorsprünge (61...64) enthält.

7. Gerät nach einem der Ansprüche 1 bis 6, wobei die zweite Fläche (16) eine aventurin-rauhe Oberfläche aufweist.

8. Gerät nach einem der Ansprüche 1 bis 7, wobei die glatten Flächenabschnitte hochglanzpoliert sind.

9. Gerät nach einem der Ansprüche 1 bis 8, wobei das elektronische Bauteil (10) eine integrierte Schaltung mit an entgegengesetzten Seiten aus der Packung (12) austretenden Zuleitungen (10) ist und somit ein Halbleitergerät mit einer Dual-In-Line-Packung darstellt.

FIG. 1

(a)

(b)

(c)

FIG. 2

9

## FIG. 3

## FIG. 4

## FIG. 5

## FIG. 6

## FIG. 7

## FIG. 8

## FIG. 9

## FIG. 10

FIG. 11

FIG. 12

FIG. 13

FIG. 14